(19) **Europäisches Patentamt**

**European Patent Office**

**Office européen des brevets**

(11) **EP 1 120 663 B1**

(12) **EUROPÄISCHE PATENTSCHRIFT**

(45) Veröffentlichungstag und Bekanntmachung des Hinweises auf die Patenterteilung:
**19.05.2004 Patentblatt 2004/21**

(51) Int Cl.$^7$: **G01R 31/36**

(21) Anmeldenummer: **00126938.0**

(22) Anmeldetag: **08.12.2000**

(54) **Verfahren zur Bestimmung des Ladezustandes von Akkumulatoren**

Determining the capacity of an accumulator

Détermination de la capacité d'un accumulateur

(84) Benannte Vertragsstaaten:
**AT BE CH CY DE DK ES FI FR GB GR IE IT LI LU MC NL PT SE TR**

(30) Priorität: **21.01.2000 DE 10002473**

(43) Veröffentlichungstag der Anmeldung:
**01.08.2001 Patentblatt 2001/31**

(73) Patentinhaber: **VB Autobatterie GmbH
30419 Hannover (DE)**

(72) Erfinder:
• **Richter, Gerolf, Dr.
31139 Hildesheim (DE)**

• **Meissner, Eberhard, Dr.
31515 Wunstorf (DE)**

(74) Vertreter: **Lins, Edgar, Dipl.-Phys. Dr.jur. et al
Gramm, Lins & Partner GbR,
Theodor-Heuss-Strasse 1
38122 Braunschweig (DE)**

(56) Entgegenhaltungen:
**EP-A- 0 560 468        GB-A- 2 006 969
US-A- 5 808 445        US-A- 5 955 869**

**Beschreibung**

Für zahlreiche Anwendungen ist es erforderlich, den aktuellen Ladezustand (state of charge = SOC)eines Akkumulators zu bestimmen.

Zunächst konzentrierten sich alle Bemühungen diesbezüglich auf die Messung und Auswertung der Elektrolytdichteänderungen, entweder direkt durch mechanische und optische Verfahren oder indirekt über die mit der Säuredichte gekoppelte Ruhespannung der Batterie bzw. der einzelnen Zellen.

Mit zunehmenden Fortschritten auf dem Gebiet der elektronischen Datenerfassung und - verarbeitung drängte sich die Methode der Ladungsbilanzierung mit Hilfe von Stromzählern in den Vordergrund.

Diese Verfahren zeigen bei Batterien im Anwendungsbereich kompletter Ladung und Entladung mit nur seltenen Zwischenladungen sehr gute Erfolge. Fehler können entstehen durch Mess- und Rechenungenauigkeiten, parasitäre Ladungsverluste im Akkumulator, die Alterung des Stromspeichers sowie sich mit der Höhe des Lade- bzw. Entladestroms ändernde entnehmbare Batteriekapazitäten. Allerdings ist es mit Hilfe solcher integrierender Verfahren nicht möglich, eine Aussage über die aktuelle Leistungsbereitschaft (Produkt Strom mal Spannung) der Batterie eine zuverlässige Aussage zu machen, da z. B. die Änderung des Innenwiderstands eine Funktion der hinsichtlich Zeitdauer und Stromhöhe vorausgegangenen Voll- bzw. Teilzyklen ist.

Die erwähnten Schwachpunkte der Ladungsbilanzierungmethode können durch eine mathematische Modellbildung des Akkumulators in zufriedenstellender Weise überwunden werden.

Verfahren mit mathematischen Modellen (beschreibenden Gleichungen bzw. mathematisch darstellbaren Ersatzschaltbildem), deren Auswertung auf elektronischen Rechenanlagen bei Vorgabe eines Satzes von batterietypischen Grunddaten bzw. Ersatzschaltbildkomponentendaten erfolgt, machen eine Ladezustandserfassung der parallel zum Modell zeitgleich betriebenen Batterie möglich. Limitierender Faktor dieser Methoden ist lediglich die Güte des zugrunde liegenden Modells, sowie die Qualität der Eingabeparameter hinsichtlich ihrer Übereinstimmung mit der zu betrachtenden Batterie.

Als Auswertemethode hat sich insbesondere der regelungstechnische Nullabgleich der über das Modell errechneten Ausgangsspannung mit der tatsächlichen Batteriespannung unter den Bedingungen gleicher Temperatur und gleichen Stromdurchsatzes als besonders brauchbar erwiesen. Diese Art der Auswertung lässt auch eine Abschätzung der Alterungsvorgänge im Akkumulator zu.

Nachteile von auf mathematischen Modellen basierenden Verfahren sind ein enormer Anstieg der Modellkomplexität, wenn insbesondere die Auswirkungen kurzzeitiger Ladungsänderungen errechnet werden sollen, und wenn andererseits aber auch große Ladungsauf- bzw. -entnahmen der Batterie über längere Zeiträume hinweg vorliegen.

Aus der US-5 955 869 ist ein Verfahren für die Bestimmung des Ladezustandes von Akkumulatoren bekannt, wobei zwei unterschiedliche Methoden zur Ladezustandbestimmung je nach Batteriezustand einzeln angewandt werden.

Die Problematik besteht darin, dass in Abhängigkeit von den hinsichtlich Zeitdauer und Geschwindigkeitsprofil statistisch verteilten Kraftfahrzeugzyklen, überlagert durch ebenfalls statistisch verteilte Leistungsaufnahmeprofile der im Auto installierten elektrischen Verbraucher, die verschiedensten Lade- bzw. Entladebedingungen für die Starterbatterie möglich sind und vom Ladezustandsermittler erfasst werden müssen.

Der Erfindung liegt die Aufgabe zugrunde, ein Verfahren zur Ermittlung des Ladezustands eines Akkumulators anzugeben, welches großen Ladungsaustausch in Relation zur Batteriekapazität, Ruhepausen und Standby-Phasen sowie Batteriealterung erfasst.

Diese Aufgabe wird erfindungsgemäß beim eingangs genannten Verfahren durch die kennzeichnenden Merkmale des Anspruchs 1 gelöst. In den Unteransprüchen sind weitere vorteilhafte Ausgestaltungen des Verfahrens angegeben.

Erfindungsgemäß sollen mehrere in ihrem Ansatz unterschiedliche Methoden zur Ladezustandsbestimmung gleichzeitig angewendet, die einzeln erhaltenen Ergebnisse dieser unterschiedlichen Methoden entsprechend ihrer jeweiligen Zuverlässigkeit während der jeweiligen aktuellen bzw. zurückliegenden Betriebssituation des Akkumulators gewichtet und der so erhaltene gewichtete Mittelwert der einzelnen Methoden als Ausgabegröße des Verfahrens verwendet und angezeigt werden. Beispielsweise wird die im Kurzzeitbereich und bei sehr großen Strömen relativ präzise arbeitende Ladungsbilanzmethode mit anderen Methoden für den Langzeitbereich kombiniert, insbesondere mit auf mathematischen Modellen beruhenden Methoden.

Durch diese Vorgehensweise können auch Ruhepausen und Standby-Phasen sowie die Batteriealterung erfasst werden. Ein weiterer Vorteil besteht darin, dass eine Plausibilitätskontrolle der Ergebnisse durch zwei unterschiedliche Ermittlungsverfahren möglich ist.

Insbesondere ist die Erfindung dadurch gekennzeichnet, dass die Spannung des Akkumulators, der durch ihn fließende Strom und seine Temperatur gemessen werden, und dass die unterschiedlichen Methoden diese Eingangsgrößen sowie aus diesen Eingangsgrößen abgeleitete Größen als Eingabegrößen verwenden.

Dabei ist mindestens eine der eingesetzten Methoden eine integrierende Methode, und mindestens eine andere Methode eine modell-gestützte Methode.

Unter einer integrierenden Methode ist dabei eine Messung des Akkumulatorstromes durch eine elektronische Baugruppe und die analog oder digital realisierte Bildung des zeitlichen Stromintegrals $\int i\, dt$ zu verstehen, wodurch auf die Änderung des Ladezustandes des Akkumulators geschlossen wird.

Unter einer modell-gestützten Methode ist die Nachbildung des Batterieverhaltens in einem elektronischen Ersatzschaltbild und deren mathematische Fassung in einer digitalen Schaltung zu verstehen. Dabei werden beispielsweise aus dem Vergleich des Verhaltens von Modell und realem Akkumulator über einen regelungstechnischen Ansatz die Parametergrößen des Modells und die Zustandsgrößen des Modells angepasst und so auf den Ladezustand des Akkumulators geschlossen.

Durch Integration des durch den Akkumulator fließenden Stromes werden die Änderungen des Ladungsinhaltes des Akkumulators bestimmt, aus denen auf Änderungen des Ladezustandes rückgeschlossen wird. Mindestens eine andere der unterschiedlichen Methoden verwendet ein auf einer elektronischen Rechenanlage realisiertes mathematisches Modell, welches das Verhalten des Akkumulators simuliert, wobei beispielsweise aber nicht zwingend aus dem Vergleich des Verhaltens von Modell und realem Akkumulator über einen regelungstechnischen Ansatz die Parametergrößen des Modells und die Zustandsgrößen des Modells angepasst und so auf den Ladezustand des Akkumulators geschlossen wird.

Zusätzlich kann durch mindestens eine der eingesetzten Methoden auf das Gebrauchsalter oder die Notwendigkeit eines Austausches des Akkumulators, die derzeitige oder zukünftige Leistungsfähigkeit oder die derzeitige oder zukünftige Verfügbarkeit des Akkumulators geschlossen werden, oder ein solcher Rückschluss auf die Verfügbarkeit des Akkumulators erfolgt durch eine Kombination der Aussagen von mehreren der eingesetzten Methoden, wobei gegebenenfalls ein gewichtetes Mittel der so erhaltenen Verfügbarkeitsaussagen der einzelnen Methoden als (weitere) Ausgabegröße des Verfahrens verwendet wird.

Erfindungsgemäß können also mindestens zwei unterschiedliche Methoden mit unterschiedlichen Stärken und Schwächen derart kombiniert werden, dass in jeder Betriebssituation mindestens eine von ihnen eine ausreichende Verlässlichkeit hinsichtlich des Ladezustandes, gegebenenfalls auch in Verbindung mit dem zu einem früheren Zeitpunkt bestimmten Ladezustand, besitzt. Je nach Betriebssituation kann eine andere der unterschiedlichen Methoden herangezogen werden. Im allgemeinen Fall wird ein gewichtetes Mittel der durch die unterschiedlichen Methoden ermittelten Ladezustände gebildet.

Die Berechnung der Wichtungsfaktoren für die Ergebnisse der unterschiedlichen Methoden erfolgt in Abhängigkeit von den Betriebsbedingungen, insbesondere der zeitlichen Verläufe von Spannung, Strom und Temperatur des Akkumulators.

Weiterhin können noch Batteriekennfelder sowie Parameter für die Berechnung der Wichtungsvorschrift eingehen.

Insbesondere können auch Methoden verwendet werden, die nur bei bestimmten Betriebszuständen aussagekräftige Ergebnisse liefern und bei anderen Betriebszuständen stärker fehlerbehaftet sind. Durch eine Wichtungsfunktion zwischen den unterschiedlichen Methoden wird sichergestellt, dass die von aussagekräftigen Methoden ermittelten Werte stark, die von unter den gegebenen Betriebszuständen stärker fehlerbehafteten Methoden ermittelten Werte nur gering in das Endergebnis des erfindungsgemäßen Verfahrens eingehen.

Der laufend nach diesem Verfahren erhaltene Ladezustandswert, oder eine andere Funktion der im Rahmen des Verfahrens nach den verwendeten verschiedenen Methoden erhaltenen Ladezustandswerte, oder deren absolute Werte, relative Größe, deren Änderung oder Änderungsrate wird zur Anzeige gebracht und/oder zur Steuerung einer Funktion in dem mit dem Akkumulator verbundenen System verwendet. Insbesondere erfolgt die Verwendung zur Steuerung der elektrischen Energien in einem Kraftfahrzeug, und der Ladezustandswert dient als wesentliche Entscheidungshilfe für diese Steuerung.

Die für die Anwendung des Verfahrens notwendigen Eingangsmesswerte werden in Abtastintervallen T1 (beispielsweise von 1 ms bis 1 s) zwischen zwei Messvorgängen für z. B. den Batteriestrom und die dazugehörige Batteriespannung ermittelt.

Ein Rechenintervall der Dauer Ti legt den Zeitraum zwischen der Bestimmung zweier Ladezustandswerte LZ (k) und/oder der Änderung des Ladezustandes $\Delta$LZ (k) nach jeder der unterschiedlichen Methoden k = 1, 2, 3, ...fest.

Die auf mathematischen Modellen basierenden Methoden laufen ohne Unterbrechung, sozusagen der Batterie zugehörig, gegebenenfalls mit Änderung der Parameter der Komponenten des Ersatzschaltbildes aufgrund der Alterung.

In einem Rechenintervall Ti werden nach den verschiedenen Methoden k = 1, 2, 3, ... die Änderungen der Ladezustandswerte $\Delta$LZi(k) ermittelt.

Die nach dem erfindungsgemäßen Verfahren erhaltene Ladezustandsänderung $\Delta$LZi ergibt sich daraus als gewichtetes Mittel

$$\Delta LZi = \alpha(1) * \Delta LZi(1) + \alpha(2) * \Delta LZi(2) + \alpha(3) * \Delta LZi(3) +......$$

Die Wichtungsfaktoren $\alpha(k)$ aller gleichzeitig eingesetzten Methoden addieren sich in ihrer Summe zum Wert "1".

Aus dem Ladezustand $LZ_{i-1}$ am Ende des vorangehenden Rechenintervalls Ti-1 und der Ladezustandsänderung $\Delta LZi$ während des Rechenintervalls Ti wird ein neuer Ladezustand LZi berechnet.

Dieser neue Ladezustandswert LZi fließt in die sich durch Vergleich mit den Messwerten iterativ an den wahren Ladezustandswert annähernden modellgestützten Methoden ein. Dadurch wird bei großen Abweichungen von LZi vom Ladezustandswert der modellgestützten Methode diese Abweichung bei der Ermittlung von $\Delta LZi+1$ jeweils besonders berücksichtigt und korrigiert.

Aus den Änderungen der Ladezustandswerte $\Delta LZi(k)$ können den verschiedenen Methoden zugeordnete Ladezustände LZi(k) berechnet werden. Der nach dem erfindungsgemäßen Verfahren erhaltene Ladezustand LZi ergibt sich daraus als gewichtetes Mittel:

$$LZi = \beta(1) * LZi(1) + \beta(2) * LZi(2) + \beta(3) * LZi(3) +.....$$

Die Wichtungsfaktoren $\beta(k)$ aller gleichzeitig eingesetzten Methoden addieren sich in ihrer Summe zum Wert "1".

Dieser neue Ladezustandswert LZi fließt in die modellgestützten Methoden ein.

Die Wichtungsfaktoren $\alpha(k)$ der nach den verschiedenen Methoden k = 1, 2, 3, ... ermittelten Ladezustandsänderungen $\Delta LZi(k)$ werden in Rechenintervallen Ti, in denen zu jedem individuellen Zeitpunkt ein kleiner Strom floss, bei auf mathematischen Modellen basierenden Methoden groß (insbesondere in ihrer Summe = 1 bei Strom =0) und bei auf Stromintegration basierenden Methoden klein (insbesondere in ihrer Summe = 0 bei Strom = 0) gewählt.

Dadurch wird der geringen Zuverlässigkeit der auf Stromintegration beruhenden Methoden bei kleinen fließenden Strömen Rechnung getragen.

Die Wichtungsfaktoren $\alpha(k)$ der nach den verschiedenen Methoden k = 1, 2, 3, ... ermittelten Ladezustandsänderungen $\Delta LZi(k)$ werden in Rechenzeitintervallen Ti, in denen ein großer Strom floss, die Änderung des Ladezustandes aber nur gering ist, bei auf mathematischen Modellen basierenden Methoden klein (insbesondere in ihrer Summe = 0 bei Ladezustandsänderung =0) und bei auf Stromintegration basierenden Methoden groß (insbesondere in ihrer Summe = 1 bei Ladezustandsänderung =0) gewählt. Dadurch wird der geringen Zuverlässigkeit der ersteren Methode bei kleinen Ladezustandsänderungen Rechnung getragen.

Ein Strom gilt dabei als klein, wenn er zu einer Änderung des Ladezustandes von nicht mehr als 1%, und vorteilhaft von nicht mehr als 0,2% der Nennkapazität der Speicherbatterie pro Stunde führt; ein Strom gilt als groß, wenn er zu einer Änderung des Ladezustandes von mehr als 10%, und vorteilhaft mehr als 20% der Nennkapazität der Speicherbatterie pro Stunde führt.

Eine Ladezustandsänderung gilt als klein, wenn sie nicht mehr als 1%, und vorteilhaft nicht mehr als 0,2% der Nennkapazität der Speicherbatterie pro Stunde beträgt; eine Ladezustandsänderung gilt als groß, wenn sie mehr als 10%, und vorteilhaft mehr als 20% der Nennkapazität der Speicherbatterie pro Stunde beträgt.

Die Wichtungsfaktoren $\alpha(k)$ der nach den verschiedenen Methoden ermittelten Ladezustandsänderungen $\Delta LZi(k)$ werden in Rechenintervallen Ti, in denen eine erhebliche Ladezustandsänderung erfolgte, bei auf mathematischen Modellen basierenden Methoden und bei auf Stromintegration basierenden Methoden in gleicher Größenordnung gewählt.

Die Wichtungsfaktoren $\alpha(k)$ der nach Stromintegrations-Methoden ermittelten Ladezustandsänderungen $\Delta LZi(k)$ werden in Rechenzeitintervallen Ti, in denen die auf mathematischen Modellen basierenden Methoden eine ungenaue Beschreibung der Batterie darstellen (häufig in Gebieten mit stark positiver Ladebilanz) gleich 1 gesetzt.

Die Wichtungsfaktoren $\alpha(k)$ der nach den verschiedenen Methoden k = 1, 2, 3, ... ermittelten Ladezustandsänderungen $\Delta LZi(k)$ werden in Rechenzeitintervallen Ti in denen keine der in den vorgenannten Beispielen beschriebenen Voraussetzungen zutreffen, durch Interpolation zwischen diesen Fällen ermittelt. Diese Interpolation kann linear oder mit einem anderen funktionalen Zusammenhang erfolgen.

Als Eckpunkte der Interpolation betreffs des fließenden Stromes und der umgesetzten Ladungsmenge werden erfindungsgemäß die folgenden Werte verwendet:

Ein Strom gilt dabei als klein, wenn er zu einer Änderung des Ladezustandes von nicht mehr als 1%, und vorteilhaft nicht mehr als 0,2% der Nennkapazität der Speicherbatterie pro Stunde führt; ein Strom gilt als groß, wenn er zu einer Änderung des Ladezustandes von mehr als 10%, und vorteilhaft mehr als 20% der Nennkapazität der Speicherbatterie pro Stunde führt. Eine Ladezustandsänderung gilt als klein, wenn sie nicht mehr als 1%, und vorteilhaft nicht mehr als 0,2% der Nennkapazität der Speicherbatterie pro Stunde beträgt; eine Ladezustandsänderung gilt als groß, wenn sie mehr als 10%, und vorteilhaft mehr als 20% der Nennkapazität der Speicherbatterie pro Stunde beträgt.

Jede der gleichzeitig angewendeten Methoden k kann ihre eigene aktuelle Zuverlässigkeit bewerten und kann einen Vorschlagswert für den Wichtungsfaktor $\alpha(k)$ bzw. $\beta(k)$ aus dem Wertebereich von 0 bis 1 vorgeben. Denn jede der Methoden kann aus den Werten ihrer Eingangsgrößen und der Historie ihrer eigenen Werteermittlung ableiten, ob sie unter den gerade vorliegenden Betriebsbedingungen eine mehr oder weniger zuverlässige Aussage zum Ladezustand und seiner Änderung machen kann. Das Verfahren normiert diese Vorschlagswerte so dass ihre Summe sich zu =1 ergibt, und berechnet dann eine Änderung des Ladezustandes oder einen Ladezustand.

Die Zuverlässigkeit einer der Methoden k hängt ab von der Art der Methode (Stromintegration, modellgestützt, etc....), von den Betriebsbedingungen der Batterie (hoher/niedriger Strom, hohe/niedrige Änderungsraten der Stromstärke, hohe/niedrige Änderungsraten des Ladezustandes, etc....) und von der Genauigkeit der Messung der Eingangsgrößen (Strom, Spannung, Temperatur, ...). Es ist bekannt, dass die Stromintegration eine verhältnismäßig gute Schätzung der geflossenen Ladung erlaubt, wenn der Strom nicht zu klein ist, andernfalls ist der Fehler bei der Strommessung, verglichen mit der Stromstärke, nicht klein genug. Stromintegration ergibt auch dann eine recht gute Schätzung der geflossenen Ladung, wenn die Messdauer nicht zu lang ist, da der Integrationsfehler mit der Zeitdauer wächst.

Modellgestützte Algorithmen können besser sein, je dynamischer die Betriebsbedingungen sind, d.h. je schneller die Eingangsgrößen Strom, Spannung etc. sich ändern. Je höher die Änderungsrate, desto mehr kann der Algorithmus über den Batteriezustand "lernen".

Dies gilt, wenn die Messungen schnell genug sind, um den Änderungen folgen zu können, sonst sinkt die Aussagegenauigkeit.

Da die verschiedenen Eingangsgrößen von den Methoden in unterschiedlicher Weise benutzt werden, können durch Berechnung der Fehlerfortpflanzung die Konsequenzen von Messfehlern auf die Ergebnisse der unterschiedlichen Methoden k berücksichtigt werden. Jeder Modellalgorithmus kann daher eine eigene relative Zuverlässigkeit bei den gegebenen Betriebsbedingungen berechnen, wobei die Messgenauigkeit und die Art des Modells berücksichtigt werden.

Die Auswertung bzw. Anwendung des nach dem beschriebenen kombinierten Verfahren ermittelten Ladezustandes ermöglicht einen sicheren und wirtschaftlichen Betriebs eines Kraftfahrzeuges.

Unterschreitet der aktuelle Ladezustand LZ eine vorgegebene Schwelle S1, so erfolgt eine Anzeige (Alarmfunktion), oder es wird eine Maßnahme ausgelöst, z.B. die Verbraucherlast vermindert oder die der Speicherbatterie zugeführte Ladeleistung erhöht.

Überschreitet der aktuelle Ladezustand LZ eine vorgegebene Schwelle S2, so erfolgt eine Anzeige (Alarmfunktion), oder es wird eine Maßnahme ausgelöst, z.B. die Verbraucherlast erhöht oder die der Speicherbatterie zugeführte Ladeleistung vermindert.

Überschreitet die Abweichung der von den verschiedenen Methoden ermittelten Ladezustände oder die Abweichung der in einem Zeitintervall ermittelten Ladezustandsänderungen eine vorgegebene Schwelle S3, so wird aufgrund dieser zu starken Abweichung zwischen den Ergebnissen nach den verschiedenen Methoden eine Anzeige oder eine Maßnahme ausgelöst.

Unterschreitet die Abweichung der von den verschiedenen Methoden ermittelten Ladezustände oder die Abweichung der in einem Zeitintervall ermittelten Ladezustandsänderungen wieder eine vorgegebene Schwelle S4, so wird die vorher ausgelöste Maßnahme wieder aufgehoben.

**Patentansprüche**

1. Verfahren zur Bestimmung des Ladezustandes eines Akkumulators, **dadurch gekennzeichnet, dass** mindestens zwei in ihrem Ansatz unterschiedliche Methoden zur Ladezustandsbestimmung gleichzeitig angewendet werden, die einzeln erhaltenen Ergebnisse der unterschiedlichen Methoden entsprechend ihrer jeweiligen Zuverlässigkeit in der jeweiligen aktuellen bzw. zurückliegenden Betriebssituation des Akkumulators gewichtet werden, und der so erhaltene gewichtete Mittelwert der einzelnen Methoden als Ausgabegröße des Verfahrens verwendet und angezeigt wird.

2. Verfahren nach Anspruch 1, **dadurch gekennzeichnet, dass** die Spannung des Akkumulators, der durch ihn fließende Strom, und seine Temperatur gemessen werden, und dass die unterschiedlichen Methoden diese Eingangsgrößen sowie aus diesen Eingangsgrößen abgeleitete Größen als Eingabegrößen verwenden.

3. Verfahren nach Anspruch 1 oder 2, **dadurch gekennzeichnet, dass** mindestens eine der unterschiedlichen Methoden die Integration des durch den Akkumulator fließenden Stromes zur Bestimmung der Änderungen des Ladungsinhaltes des Akkumulators nutzt, aus der auf Änderungen des Ladezustandes rückgeschlossen wird, und dass mindestens eine andere der unterschiedlichen Methoden ein auf einer elektronischen Rechenanlage realisiertes mathematisches Modell verwendet, welches das Verhalten des Akkumulators simuliert.

4. Verfahren nach einem der Ansprüche 1 bis 3,**dadurch gekennzeichnet, dass** zusätzlich durch mindestens eine der eingesetzten Methoden auf das Gebrauchsalter oder die Notwendigkeit eines Austausches des Akkumulators, die derzeitige oder zukünftige Leistungsfähigkeit oder die derzeitige oder zukünftige Verfügbarkeit des Akkumulators geschlossen wird.

5. Verfahren nach einem oder mehreren der Ansprüche 1 bis 4, **dadurch gekennzeichnet, dass** die in einem Rechenintervall Ti erhaltene Änderung des Ladezustandes ΔLZi als gewichtetes Mittel der nach den verschiedenen Methoden k = 1, 2, 3, ... ermittelten Ladezustandsänderungen ΔLZi(k) errechnet wird:

$$ΔLZi = α(1) * ΔLZi(1) + α(2) * ΔLZi(2) + α(3) * ΔLZi(3) +....,$$

wobei die Wichtungsfaktoren α(k) aller gleichzeitig eingesetzten Methoden in ihrer Summe sich zum Wert "1" addieren, und dass aus dem Ladezustand LZi-1 vor dem Rechenintervall Ti und der Ladezustandsänderung ΔLZi während des Rechenintervalls Ti ein neuer Ladezustand LZi berechnet wird, der als Ausgabegröße des Verfahrens verwendet und angezeigt wird.

6. Verfahren nach einem oder mehreren der Ansprüche 1 bis 5., **dadurch gekennzeichnet, dass** mit den in einem Rechenintervall Ti nach verschiedenen Methoden k = 1, 2, 3, ... ermittelten Ladezustandsänderungen ΔLZi(k) den verschiedenen Methoden zugeordnete Ladezustände LZi(k) berechnet werden, und hieraus als gewichtetes Mittel ein Ladezustand LZi des Verfahrens bestimmt wird:

$$LZi = β(1) * LZi(1) + β(2) * LZi(2) + β(3) * LZi(3) +....,$$

wobei die Wichtungsfaktoren β(k) aller gleichzeitig eingesetzten Methoden in ihrer Summe sich zum Wert "1" addieren, und dass dieser neue Ladezustandswert LZi in die modellgestützten Verfahren einfließt.

7. Verfahren nach einem oder mehreren der Ansprüche 1 bis 6., **dadurch gekennzeichnet, dass** die Wichtungsfaktoren α(k) der nach den verschiedenen Methoden k = 1, 2, 3, ... ermittelten Ladezustandsänderungen ΔLZi(k)

　　a) in Rechenzeitintervallen Ti, in denen zu jedem individuellen Zeitpunkt ein kleiner Strom floss, bei auf mathematischen Modellen basierenden Methoden groß und bei auf Stromintegration basierenden Methoden klein gewählt werden,
　　b) in Rechenzeitintervallen Ti, in denen ein großer Strom floss, die Änderung des Ladezustandes aber nur gering ist, bei auf mathematischen Modellen basierenden Methoden klein und bei auf Stromintegration basierenden Methoden groß gewählt werden,
　　c) in Rechenzeitintervallen Ti , in denen eine erhebliche Ladezustandsänderung erfolgte, bei auf mathematischen Modellen basierenden Methoden und bei auf Stromintegration basierenden Methoden in gleicher Größenordnung gewählt werden.
　　d) in Rechenzeitintervallen Ti, in denen keine der Voraussetzungen a), b), c) zutreffen, durch Interpolation zwischen diesen Fällen ermittelt werden.

8. Verfahren nach einem oder mehreren der Ansprüche 1 bis 7, **dadurch gekennzeichnet, dass** jede Methode k ihre eigene aktuelle Zuverlässigkeit bewertet und einen Vorschlagswert für α(k) aus dem Wertebereich von 0 bis 1 vorgibt, dass das Verfahren diese Vorschlagswerte normiert so dass ihre Summe sich zu =1 ergibt, und dass dann eine Änderung des Ladezustandes oder ein Ladezustand berechnet wird.

9. Verfahren nach einem oder mehreren der Ansprüche 1 bis 8 , **dadurch gekennzeichnet, dass** der ermittelte Ladezustandswert oder eine andere Funktion der erhaltenen Ladezustandswerte oder deren absolute Werte, relative Größe, deren Änderung oder Änderungsrate zur Anzeige gebracht und zur Steuerung einer Funktion in dem mit dem Akkumulator verbundenen System verwendet wird.

**Claims**

1. Method for determination of the state of charge of a rechargeable battery, **characterized in that** at least two methods based on different approaches are used at the same time to determine the state of charge, the individually obtained results from the different methods are weighted on the basis of their respective reliability in the respective present or previous operating situation of the rechargeable battery, and the weighted mean value obtained in this way from the individual methods is used and is indicated as the output variable of the method.

2. Method according to Claim 1, **characterized in that** the voltage of the rechargeable battery, the current flowing through it and its temperature are measured, and **in that** the different methods use these input variables as well as variables derived from these input variables as initial variables.

3. Method according to Claim 1 or 2, **characterized in that** at least one of the different methods uses the integration of the current flowing through the rechargeable battery in order to determine the changes in the charge content of the rechargeable battery, from which changes in the state of charge are deduced, and **in that** at least one other of the different methods uses a mathematical model, which is run on an electronic computation system and simulates the behaviour of the rechargeable battery.

4. Method according to one of Claims 1 to 3, **characterized in that**, in addition, at least one of the methods which are used is or are used to deduce the usage age or the need for replacement of the rechargeable battery, the present or future performance capability, or the present or future availability of the rechargeable battery.

5. Method according to one or more of Claims 1 to 4, **characterized in that** a change in the state of charge $\Delta LZi$ recorded in a computation interval $Ti$ is calculated as a weighted mean of the changes $\Delta LZi(k)$ in the state of charge determined using the different methods $k = 1, 2, 3, ...$:

$$\Delta LZi = \alpha(1) * \Delta LZi(1) + \alpha(2) * \Delta LZi(2) + \alpha(3) * \Delta LZi(3) + ...,$$

where the weighting factors $\alpha(k)$ of all the methods which are used at the same time are added up in total to the value "1", and **in that** a new state of charge $LZi$ is calculated from the state of charge $LZi-1$ before the computation interval $Ti$ and from the state of charge $\Delta LZi$ during the computation interval $Ti$, and is used and indicated as the output variable of the method.

6. Method according to one or more of Claims 1 to 5, **characterized in that** states of charge $LZi(k)$ which are associated with the various methods are calculated from the state of charge changes $\Delta LZi(k)$ determined using the different methods $k = 1, 2, 3, ...$ in a computation interval $Ti$, and a state of charge $LZi$ for the method is determined from this as a weighted mean:

$$LZi = \beta(1) * LZi(1) + \beta(2) * LZi(2) + \beta(3) * LZi(3) + ...,$$

with the weighting factors $\beta(k)$ of all of the methods which are used at the same time adding up in total to the value "1", and **in that** this new state of charge value $LZi$ is included in the model-based method.

7. Method according to one or more of Claims 1 to 6, **characterized in that** the weighting factors $\alpha(k)$ of the state of charge changes $\Delta LZi(k)$ determined using the different methods $k = 1, 2, 3, ...$

   a) are chosen, in computation time intervals $Ti$ in which a small current flowed at each individual time, to be large for methods based on mathematical models and to be small for methods based on current integration,
   b) are chosen, in computation time intervals $Ti$ in which a large current flowed, but in which the change in the state of charge is only low, to be small for methods based on mathematical models and to be large for methods based on current integration,
   c) are chosen, in computation time intervals $Ti$ in which a considerable state of charge change occurred, to be in the same order of magnitude for methods based on mathematical models and for methods based on current integration,
   d) are determined, in computation time intervals $Ti$ in which none of the preconditions a), b), c) are satisfied, by interpolation between these cases.

8. Method according to one or more of Claims 1 to 7, **characterized in that** each method k assesses its own present reliability and presets a proposed value a (k) from the value range from 0 to 1, **in that** the method normalizes these proposed values such that their sum is equal to 1, and **in that** a state of charge or a change in the state of charge is then calculated.

9. Method according to one or more of Claims 1 to 8, **characterized in that** the determined state of charge value or some other function of the state of charge values which are obtained or their absolute values, their relative magnitude, their change or the range of change are/is indicated and are/is used to control a function in the system which is connected to the rechargeable battery.

**Revendications**

1. Procédé pour déterminer l'état de charge d'un accumulateur,
   **caractérisé en ce qu'**
   au moins deux méthodes d'approches différentes sont utilisées simultanément pour déterminer l'état de charge, les résultats de chaque méthode obtenus individuellement lors de leur mise en application sont pondérés en fonction de leur fiabilité respective dans la situation de fonctionnement respective actuelle ou précédente de l'accumulateur, et la valeur moyenne pondérée ainsi obtenue de chacune des méthodes est utilisée et affichée comme grandeur de sortie du procédé.

2. Procédé selon la revendication 1,
   **caractérisé en ce que**
   la tension de l'accumulateur, le courant qui y circule, et sa température sont mesurés, et les différentes méthodes utilisent comme données de départ ces grandeurs d'entrée ainsi que des grandeurs dérivant de ces grandeurs d'entrée.

3. Procédé selon la revendication 1 ou 2,
   **caractérisé en ce qu'**
   au moins l'une des différentes méthodes utilise l'intégration du courant circulant dans l'accumulateur pour déterminer les modifications du contenu de charge de l'accumulateur, à partir de laquelle on déduit les modifications de l'état de charge, et au moins une autre des différentes méthodes utilise un modèle mathématique réalisé sur un ordinateur, lequel simule le comportement de l'accumulateur.

4. Procédé selon l'une quelconque des revendications 1 à 3,
   **caractérisé en ce qu'**
   au moins l'une des méthodes utilisées permet de déduire en outre la durée d'utilisation ou la nécessité de changer l'accumulateur, la puissance actuelle ou future ou la disponibilité actuelle ou future de l'accumulateur.

5. Procédé selon l'une ou plusieurs des revendications 1 à 4,
   **caractérisé en ce que**
   la modification de l'état de charge $\Delta LZi$ contenue dans un intervalle de calcul Ti est calculée comme moyenne pondérée des modifications de capacité $\Delta LZi(k)$ calculées selon les différentes méthodes k = 1, 2, 3... :

$$\Delta LZi = \alpha(1) * \Delta LZi(1) + \alpha(2) * \Delta LZi(2) + \alpha(3) * \Delta LZi(3) +...,$$

   la somme des facteurs de pondération $\alpha(k)$ de toutes les méthodes utilisées simultanément s'additionnant à la valeur « 1 », et un nouvel état de charge LZi est calculé à partir de l'état de charge LZi-1 avant l'intervalle de calcul Ti et de la modification de l'état de charge $\Delta LZi$ pendant l'intervalle de calcul Ti, lequel nouvel état de charge est utilisé et affiché comme grandeur de sortie du procédé.

6. Procédé selon l'une ou plusieurs des revendications 1 à 5,
   **caractérisé en ce que**
   des états de charge LZi(k) associées aux différentes méthodes sont calculées avec les modifications de l'état de charge $\Delta LZi(k)$ calculées dans un intervalle de calcul Ti selon les différentes méthodes k = 1, 2, 3..., et qu'à partir de ces états de charge, on détermine un état de charge LZi du procédé comme moyenne pondérée :

$$LZi = \beta(1) * LZi(1) + \beta(2) * LZi(2) + \beta(3) * LZi(3) +...,$$

la somme des facteurs de pondération $\beta(k)$ de toutes les méthodes utilisées simultanément s'additionnant à la valeur « 1 », et cette nouvelle valeur de l'état de charge LZi adopte le modèle à la base du procédé.

7.  Procédé selon l'une ou plusieurs des revendications 1 à 6,
    **caractérisé en ce que**
    les facteurs de pondération $\alpha(k)$ des modifications de l'état de charge $\Delta LZi(k)$ calculées selon les différentes méthodes k = 1, 2, 3,...sont :

    a) sélectionnés comme étant grands dans le cas de méthodes basées sur des modèles mathématiques et petits dans le cas de méthodes basées sur une intégration du courant, dans les intervalles temporels de calcul Ti dans lesquels un courant plus petit a circulé à chaque moment individuel,
    b) sélectionnés comme étant petits dans le cas de méthodes basées sur des modèles mathématiques et grands dans le cas de méthodes basées sur une intégration du courant, dans les intervalles temporels de calcul Ti dans lesquels un fort courant a circulé, mais que la modification de l'état de charge est faible,
    c) sélectionnés comme étant du même ordre de grandeur dans le cas de méthodes basées sur des modèles mathématiques et dans le cas de méthodes basées sur une intégration du courant, dans les intervalles temporels de calcul Ti dans lesquels a eu lieu une modification importante de l'état de charge,
    d) sont calculés par interpolation entre ces cas, dans les intervalles temporels de calcul Ti dans lesquels on ne rencontre aucune des conditions a) b) c).

8.  Procédé selon l'une ou plusieurs des revendications 1 à 7,
    **caractérisé en ce que**
    chaque méthode k pondère sa propre fiabilité actuelle et prédéfinit une valeur suggérée à partir d'une plage de valeurs de 0 à 1 pour $\alpha(k)$, **en ce que** le procédé uniformise ces valeurs suggérées de sorte que leur somme = 1, et **en ce qu'**ensuite une modification de l'état de charge ou un état de charge est calculé(e).

9.  Procédé selon l'une ou plusieurs des revendications 1 à 8,
    **caractérisé en ce qu'**
    on affiche la valeur de l'état de charge calculée ou une autre fonction des valeurs de l'état de charge obtenues ou leurs valeurs absolues, leur valeur relative, leur modification ou leur taux de modification, et on les utilise pour commander une fonction dans le système raccordé à l'accumulateur.